# EUROPÄISCHE PATENTSCHRIFT

(11) **EP 1 468 593 B1**
(45) Veröffentlichungstag und Bekanntmachung des Hinweises auf die Patenterteilung: **04.05.2005**
(21) Anmeldenummer: 03702338.9
(22) Anmeldetag: 17.01.2003
(51) Int. Cl.: H05K 5/02, H05K 7/14, H05K 7/18

(54) **SERVERRACK**
SERVER RACK
BATI DE SERVEUR

(30) Priorität: 25.01.2002 DE 10202917
(43) Veröffentlichungstag der Anmeldung: 20.10.2004
(73) Patentinhaber: Fujitsu Siemens Computers GmbH, 80807 München (DE)
(72) Erfinder: RIEKEN, Ralf, 32805 Horn Bad Meinberg (DE); SCHMIDT, Heinrich, 33129 Delbrück (DE); DROOP, Jürgen, 33330 Gütersloh (DE); KNOOP, Franz-Josef, 33142 Büren (DE)
(74) Vertreter: Epping, Hermann, Fischer
(86) Internationale Anmeldenummer: PCT/DE2003/000134
(87) Internationale Veröffentlichungsnummer: WO 2003/063565

(56) Entgegenhaltungen:
- US-A- 5 748 443
- US-B1- 6 219 256

## Beschreibung

Die Erfindung betrifft Serverrack zur Aufnahme mehrerer Rechnersysteme. Bisher werden in einem Serverrack die Rechnersysteme fest eingebaut und an der Rückseite verkabelt beziehungsweise verdrahtet. Ebenso ist es bekannt, die Rechnersysteme in sogenannte Einschübe zu integrieren, welche seitlich über Teleskopschienen mit dem Serverrack verbunden sind und für Wartungsarbeiten beziehungsweise zum Umrüsten nach vorne schubladenartig herausgezogen werden können. Die Verkabelung erfolgt ebenso wieder an der Rückseite. Beim Herausziehen muß das System entkabelt werden oder es müssen besondere Kabelführungen existieren, die die Kabel bei der Bewegung des Systems mitführen.

Inzwischen werden Rechnersysteme mit nur einer Höheneinheit, sogenannte Thin Server, vom Markt nachgefragt, um durch Mehrfachverwendung in einem Rechnerverbund die Gesamtrechnerleistung den Leistungsanforderungen der Anwendungsprogramme anzupassen und ein kontinuierliches Wachstum des Verbundes zu ermöglichen.

Ein Serverrack gemäß dem Oberbegriff von Anspruch 1 wird in US-A-5 748 443 offenbart.

Die kleineren Rechnersysteme weisen bei der genannten Bauform für 19" Aufnahmesysteme eine Höhe von 44,45 mm auf. Die hohe Anzahl solcher kleiner Rechnersysteme in einem Verbund bringt jedoch den Nachteil mit sich, daß die Verkabelung der Einzelsysteme auf engem Raum erfolgen muß und somit äußerst unübersichtlich wird. Bei Wartungsarbeiten oder im Falle des Hinzufügens weiterer Rechnersysteme führt dies zu erheblichen Problemen.

Der Erfindung liegt daher die Aufgabe zugrunde, eine Lösung aufzuzeigen; wodurch bei einem Serverrack die Wartung, der Tausch oder das Hinzufügen eines neuen Rechnersystems vereinfacht wird.

Diese Aufgabe wird erfindungsgemäß gelöst durch eine Steckvorrichtung für ein oder mehrere Rechnersysteme, wobei ein oder mehrere Rechnersysteme in je einem Aufnahmeadapter aufgenommen sind, welcher zum einen die Anschlüsse für die Rechnersysteme und zum anderen die Anschlüsse für die Steckvorrichtung aufweist, so daß die Rechnersysteme durch den Aufnahmeadapter ohne zusätzliche Anschlüsse in die Steckvorrichtung einsteckbar sind. Die Kabelanschlüsse werden dadurch auf gleichartige Anschlüsse auf die Steckvorrichtung verlagert.

Durch die Kombination der Steckvorrichtung mit dem Aufnahmeadapter wird es daher möglich, einzelne oder mehrere Rechnersysteme, die in je einem Aufnahmeadapter aufgenommen sind, in die Steckvorrichtung einzuschieben und zum Wechseln oder zu Wartungsarbeiten, ohne aufwendiges Lösen der Verkabelung an der Rückseite, herauszunehmen.

Der Aufnahmeadapter kann hierzu nur lediglich für ein Rechnersystem, wie zum Beispiel ein 19" Rechnersystem mit einer Höheneinheit, ein sogenannter Thin Server ausgebildet sein, jedoch ebenso auch für mehrere Thin Server oder größere Rechnersysteme konzipiert sein.

Der Aufnahmeadapter ist vorteilhafterweise so ausgelegt, daß er die Rechnersysteme entweder nur seitlich oder komplett hüllenartig umschließt und an der Rückseite einen Rahmen für die Anschlüsse des Rechnersystems und der Steckvorrichtung aufweist.

Die Steckvorrichtung weist gemäß einer bevorzugten Ausführungsform eine Lokalitätsbezeichnung für jeden Steckplatz auf, welche durch eine elektronische Schnittstelle für den Rechner abrufbar ist, der sich auf diesem steckplatz befindet. Die Lokalitätsbezeichnungen können durch geeignete Softwareprogramme dem Wartungspersonal auf einem Bildschirm, z.B. in Form einer graphischen Darstellung angezeigt werden

Die Lokalitätsbezeichnungen sind günstigerweise so gewählt, daß innerhalb der Steckvorrichtung entweder aufsteigend oder absteigend jedem belegbaren Steckplatz eine fortlaufende Nummer zugewiesen wird.

Eine Weiterbildung sieht vor, daß auch bei mehreren in das Serverrack eingesetzten Steckvorrichtungen die Lokalitätsbezeichnung von einer Steckvorrichtung zur nächsten weitergegeben wird und somit über das gesamte Serverrack alle belegten Steckplätze durchlaufend nummeriert sind.

Nachfolgend wird die Erfindung anhand zweier in den Figuren dargestellter Ausführungsbeispiele näher erläutert.

In den Figuren zeigen:
- Figur 1: eine Schrägansicht eines Serverracks mit einer Steckvorrichtung und vier Aufnahmeadaptern für Thin Server,
- Figur 2: das Serverrack gemäß Figur 1 in der Ansicht von hinten
- Figur 3: die Steckvorrichtung mit einem Aufnahmeadapter in einer schrägen Ansicht von hinten,
- Figur 4: ein Aufnahmeadapter für Thin Server in einer schrägen Ansicht von vorn und
- Figur 5: die Ansicht gemäß Figur 4 von oben.

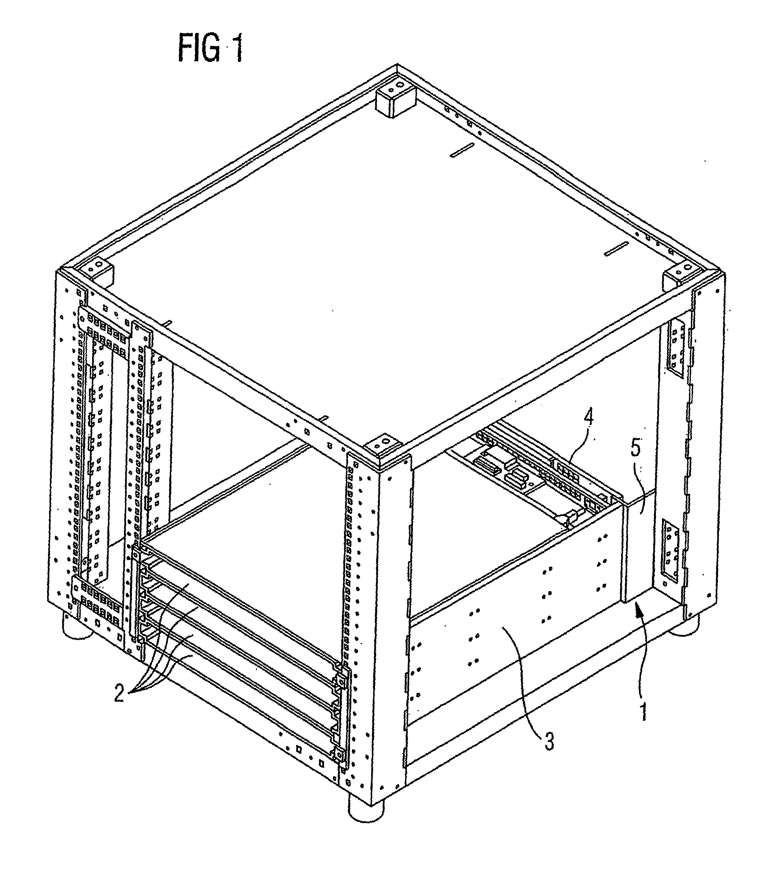

Figur 1 zeigt ein Serverrack in einer Schrägansicht, wobei von dem Serverrack die Seitenverkleidungen nicht dargestellt sind. Innerhalb des Serverracks ist eine Steckvorrichtung 1 aufgenommen, in welche vier Aufnahmeadapter 2 eingesetzt sind. Die Steckvorrichtung 1 besteht aus seitlichen Flanschen 3 sowie einer Rückwand 4, in welcher die Aufnahmeadapter 2 eingesteckt werden können. Seitlich der Rückwand 4 sind ebenso Flansche 5 zur Befestigung der Steckvorrichtung am Serverrack hervorgesehen.

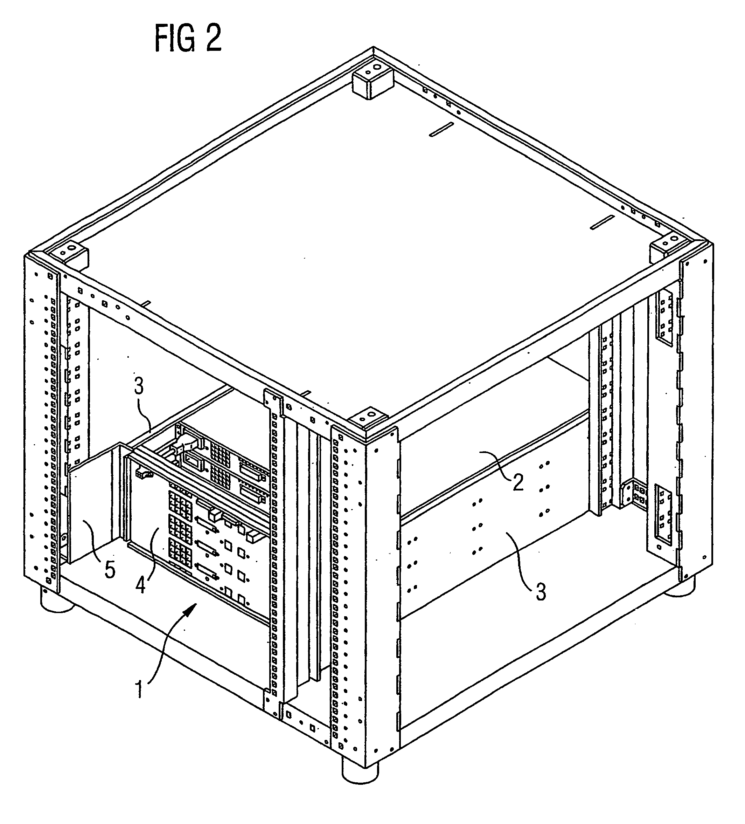

Figur 2 zeigt das Serverrack gemäß Figur 1 in einer Ansicht von schräg hinten.

Durch die seitlichen Flansche 5 kann zum einen die Steckvorrichtung 1 festgelegt werden und zum anderen steht ein Raum für die Verkabelung von mehreren Steckvorrichtungen untereinander sowie zum Zuführen der Kabel an die Steckvorrichtung zur Verfügung.

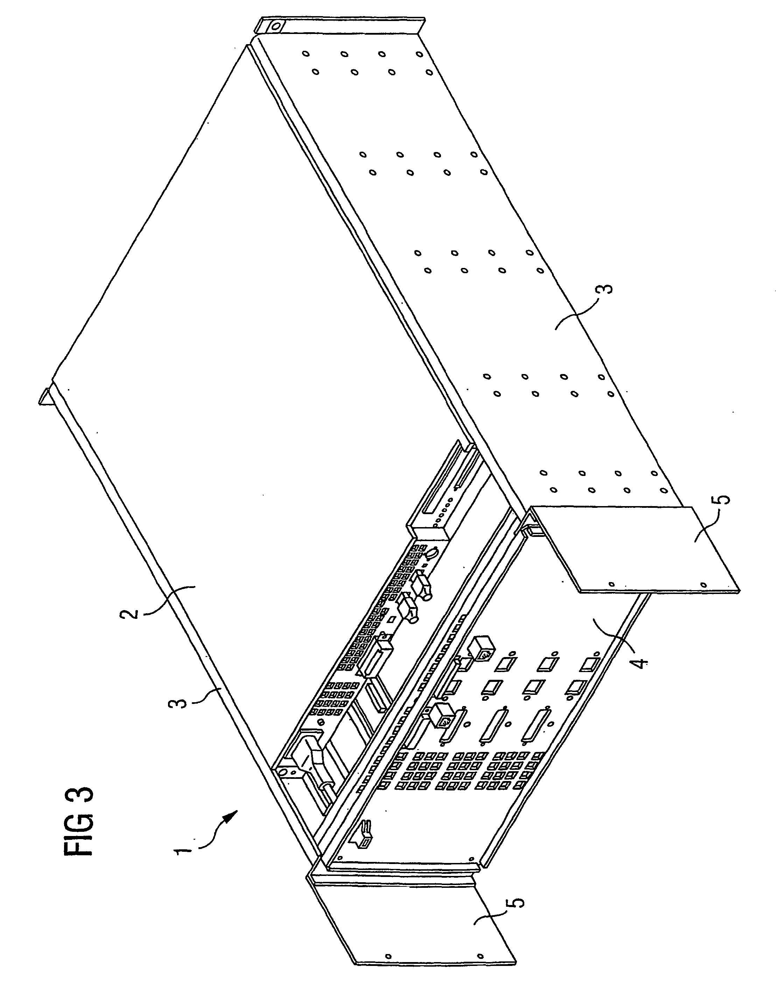

Figur 3 zeigt eine Steckvorrichtung isoliert in einer Ansicht von schräg hinten. Der Aufnahmeadapter 2 wird lediglich in einen entsprechenden Steckplatz in die Steckvorrichtung 1 eingesteckt.

Im dargestellten Ausführungsbeispiel weist die Steckvorrichtung vier übereinandergeordnete Steckplätze auf, wobei lediglich der obere Steckplatz durch einen Aufnahmeadapter belegt ist. Seitlich wird der Aufnahmeadapter über entsprechende Bohrungen mit den seitlichen Flanschen 3 verschraubt oder es werden Teleskopschienen zwischen Aufnahmeadapter 2 und den Flanschen 3 angeordnet, mit welchem die Aufnahmeadapter wiederum verschraubt werden können.

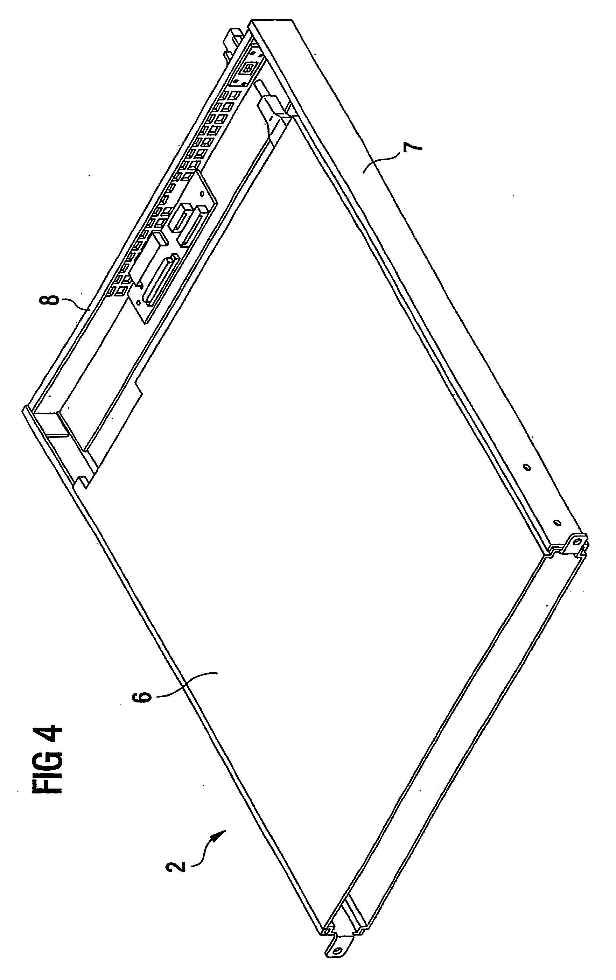

In Figur 4 ist der Aufnahmeadapter 2 isoliert dargestellt. Der Aufnahmeadapter 2 weist einen hüllenartigen Bereich 6 auf, welcher das aufzunehmende Rechnersystem umschließt. Am hüllenartigen Bereich 6 ist seitlich ein u-förmiger Rahmen 7 befestigt, welcher eine von dem hüllenartigen Bereich 6 beabstandete Stirnseite 8 aufweist, die als Steckadaption ausgebildet ist. An der Innenseite der Stirnseite 8 ist es möglich, das aufzunehmende Rechensystem anzuschließen und die Außenseite der Stirnseite 8 ist so ausgebildet, daß sie in die Steckvorrichtung 1 eingesteckt werden kann.

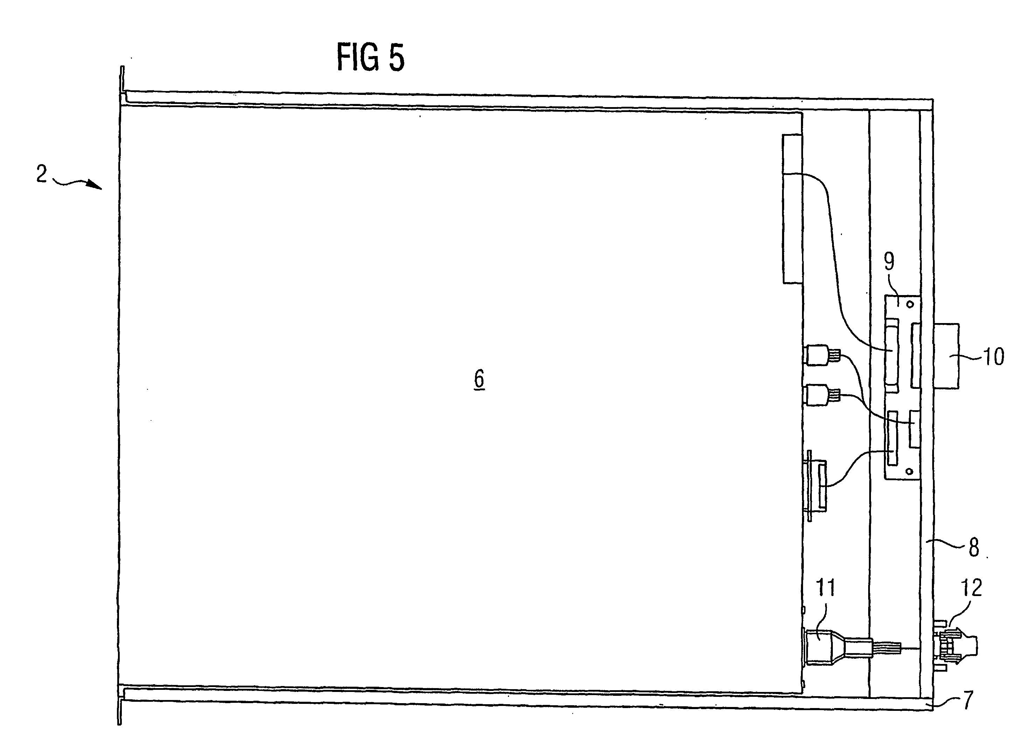

Figur 5 zeigt den Aufnahmeadapter 2 gemäß Figur 4 in der Ansicht von oben. An der Stirnseite 8 ist an der Innenseite eine Steckadaption 9 vorgesehen, in welcher die regulären Stekker zum Anschluß der Rechensysteme eingesteckt werden können. Außenseitig der Stirnseite 8 ist ein Stecker 10 angeordnet, welcher mit einer Steckeraufnahme in der Steckvorrichtung 1 zusammenwirkt. An der Stirnseite 8 können an der Innenseite weitere Anschlüsse 11 kontaktiert werden, welche an der Außenseite der Stirnseite 8 ebenfalls Stecker 12 aufweisen, die mit weiteren Steckeraufnahmen in der Steckvorrichtung 1 zusammenwirken.

Wie in den Figuren 1 bis 5 beispielhaft dargestellt, können in einer Steckvorrichtung mehrere Rechensysteme mit nur einer Höheneinheit aufgenommen werden. Ebenso ist es auch möglich, in einer Steckvorrichtung Rechensysteme mit mehreren Höheneinheiten oder gemischt Rechensysteme mit nur einer und Rechensysteme mit mehreren Höheneinheiten aufzunehmen, sofern die Art und Anzahl der Rechenschnittstellen identisch ist.

### Bezugszeichenliste

- 1: Steckvorrichtung
- 2: Aufnahmeadapter
- 3: Flansche
- 4: Rückwand
- 5: Flansche
- 6: hüllenartiger Bereich
- 7: u-förmiger Rahmen
- 8: Stirnseite
- 9: Steckadaption
- 10: Stecker
- 11: Anschlüsse
- 12: Stecker

## Patentansprüche

1. Serverrack zur Aufnahme mehrerer Rechensysteme, mit einer Steckvorrichtung (1) für ein oder mehrere Rechnersysteme, **dadurch gekennzeichnet, daß** ein oder mehrere Rechnersysteme in je einem Aufnahmeadapter (2) aufgenommen sind, welcher zum einen Anschlüsse (9, 11) für das oder die Rechnersysteme und zum anderen Anschlüsse (10, 12) für eine Steckvorrichtung aufweist, so daß das oder die Rechnersysteme durch den Aufnahmeadapter (2) in die Steckvorrichtung einsteckbar sind.

2. Serverrack nach Anspruch 1,
**dadurch gekennzeichnet, daß**
der Aufnahmeadapter (2) für 19" Rechnersysteme mit einer oder mehreren Höheneinheiten von 44,45 mm ausgebildet ist.

3. Serverrack nach Anspruch 1 oder 2,
**dadurch gekennzeichnet, daß**
der Aufnahmeadapter (2) das Rechensystem hüllenartig umschließt und einen u-förmigen Rahmen (7) für die Anschlüsse des oder der Rechensysteme beziehungsweise der Steckvorrichtung (1) aufweist.

4. Serverrack nach einem der Ansprüche 1 bis 3,
**dadurch gekennzeichnet, daß**
jeder Steckplatz der Steckvorrichtung (1) eine Lokalitätsbezeichnung aufweist, welche durch eine elektronische Schnittstelle vom Rechensystem abrufbar ist.

5. Serverrack nach Anspruch 4,
**dadurch gekennzeichnet, daß**
die Lokalitätsbezeichnung innerhalb einer Steckvorrichtung (1) bei den Steckplätzen fortlaufend durchnummeriert ist.

6. Serverrack nach Anspruch 4 oder 5,
**dadurch gekennzeichnet, daß**
eine Steckvorrichtung mit einer benachbarten Steckvorrichtung derart verbunden ist, daß die Steckplätze über mehrere Steckvorrichtungen hinweg durchlaufend nummeriert sind.

## Claims

1. Server rack for holding a plurality of computer systems, having a plugin apparatus (1) for one or more computer systems, **characterized in that** one or more computer systems are held in a respective holding adapter (2) which firstly has connections (9, 11) for the computer system(s) and secondly has connections (10, 12) for a plugin apparatus, so that the computer system(s) can be plugged into the plugin apparatus by the holding adapter (2).

2. Server rack according to Claim 1,
**characterized in that**
the holding adapter (2) is designed for 19" computer systems with one or more 44.45 mm vertical modules.

3. Server rack according to Claim 1 or 2,
**characterized in that**
the holding adapter (2) encloses the computer system in the manner of a casing and has a U-shaped frame (7) for the connections on the computer system(s) or on the plugin apparatus (1).

4. Server rack according to one of Claims 1 to 3,
**characterized in that**
each slot in the plugin apparatus (1) has a locality descriptor which can be retrieved by an electronic interface associated with the computer system.

5. Server rack according to Claim 4,
**characterized in that**
the locality descriptor is numbered consecutively from beginning to end at the slots within a plugin apparatus (1).

6. Server rack according to Claim 4 or 5,
**characterized in that**
a plugin apparatus is connected to an adjacent plugin apparatus such that the slots are numbered in sequence over a plurality of plugin apparatuses.

## Revendications

1. Bâti de serveur destiné à recevoir plusieurs systèmes informatiques comportant un dispositif d'enfichage (1) pour un ou pour plusieurs systèmes informatiques,
**caractérisé en ce qu'**un ou plusieurs systèmes informatiques sont respectivement placés dans un adaptateur de logement (2) équipé d'une part de raccordements (9, 11) pour le ou les systèmes informatiques et d'autre part de raccordements (10, 12) pour un dispositif d'enfichage, de sorte que le ou les systèmes informatiques peuvent être introduits dans le dispositif d'enfichage à l'aide de l'adaptateur de logement (2).

2. Bâti de serveur selon la revendication 1, **caractérisé en ce que**
l'adaptateur de logement (2) est conçu pour des systèmes informatiques de 19" équipés d'une ou de plusieurs unités en hauteur de 44,45 mm.

3. Bâti de serveur selon la revendication 1 ou 2, **caractérisé en ce que**
l'adaptateur de logement (2) entoure le système informatique à la manière d'une enveloppe et présente un cadre en U (7) pour raccorder le ou les systèmes informatiques ou le dispositif d'enfichage (1).

4. Bâti de serveur selon l'une des revendications 1 à 3, **caractérisé en ce que**
chaque baie du dispositif d'enfichage présente une désignation d'emplacement qui peut être appelée par le système par l'intermédiaire d'une interface électronique.

5. Bâti de serveur selon la revendication 4, **caractérisé en ce que**
la désignation d'emplacement sur les baies est numérotée en continu à l'intérieur d'un dispositif d'enfichage (1).

6. Bâti de serveur selon la revendication 4 ou 5, **caractérisé en ce que**
un dispositif d'enfichage est relié à un dispositif d'enfichage voisin de telle manière que les baies sont numérotées en continu sur plusieurs dispositifs d'enfichage.
